# EUROPEAN PATENT SPECIFICATION

(11) **EP 0 723 166 B1**
(45) Date of publication and mention of the grant of the patent: **08.03.2000**
(21) Application number: 95100627.9
(22) Date of filing: 18.01.1995
(51) Int. Cl.: G01V 3/08, H03K 17/955

(54) **Capacitive sensor**
Kapazitiver Sensor
Capteur capacitif

(43) Date of publication of application: 24.07.1996
(73) Proprietor: Carlo Gavazzi Services AG, 6312 Steinhausen (CH)
(72) Inventor: Munch, Gaute, CH-6312 Steinhausen (CH)
(74) Representative: Kehl, Günther, Dipl.-Phys.

(56) References cited:
- WO-A-90/14604
- DE-A- 3 125 925
- FR-A- 2 271 538
- GB-A- 1 515 431
- DONALD G. FINK ET AL. 'Electronics Engineers' Handbook' 1983 , MCGRAW-HILL , US NEW YORK * page 17-36, paragraph 100 * * page 17-37; figures 17-61 *

## Description

The present invention generally relates to the field of electronic sensors, switches, or transducers. In particular, the present invention relates to a sensor using a capacitive measuring principle, a so-called capacitive sensor comprising capacitance sensing means and oscillator means, for measuring capacitive changes, the oscillator means comprising a unity gain buffer for buffering the voltage over the capacitance sensing means without imposing any load on the latter, the output terminal of the unity gain buffer being connected to the input terminal of charging means for charging and discharging the capacitance sensing means via a resistor which is connected to the capacitance sensing means and to the output of the charging means, the capacitive sensor further comprising guard means connected to the output of the unity gain buffer and arranged to at least partially surround the capacitance sensing means to shield the capacitance sensing means from capacitive changes caused by interferential action.

Electronic sensors of the prior art are commonly implemented in electric control circuits or electric regulator circuits. Unlike mechanically manipulated electric sensors, they are realized in a non-contacting way. This is especially true for so-called capacitive proximity switches which nowadays work without exception in a contactless manner. Such capacitive proximity switches are used for detecting how close an object the corresponding capacitive proximity switch is sensitive for has approached this capacitive proximity switch. If such an object has reached a certain predetermined distance from the electronic sensor the capacitive proximity switch is activated by means indicating the presence of the object. In the case of an electronic sensor being implemented as a make contact, the non-conductive electronic switch now becomes conductive, in the case of an electronic sensor being implemented as a break contact, the conductive electronic switch now becomes nonconducting. Electronic sensors of this well-known type are also used to detect whether a physical quantity of a medium the electronic sensor is sensitive for has reached a corresponding predetermined value.

Thus, the means indicating the presence of the object to be detected is an essential part of electronic switching devices such as described above. Such a means indicating the presence of the object is for example realized by an oscillator circuit which is capacitively or inductively controlled. Alternatively, a so-called optoelectronic proximity switch, for instance a photo resistor, a photo diode or a photo transistor can be used to detect the presence of the object.

Conventional capacitive proximity switches are implemented in such a manner that a sensing capacitance is connected in series to an oscillator circuit. The operation of this oscillator circuit can be described by the product f·A where f is the feedback factor and A the amplification factor. As long as a certain object approaching a conductive sensing plate has not sufficiently increased the capacitance of the capacitive proximity switch, the relation f·A < 1 is valid for the oscillator circuit, i. e. the distance of the object from the capacitive proximity switch is still too large so as to trigger an oscillation. With the object reaching a predetermined distance from the capacitive proximity switch the growing capacitance between the object and the conductive sensing plate results in an augmentation of the feedback factor f (with the amplification factor A being constant). With the sensing capacitance being charged beyond a corresponding threshold and, consequently, the product f·A reaching the value 1, the oscillator circuit starts operating on the edge of the oscillation. The amplitude level of the oscillation is detected and used as an ON / OFF signal.

International Patent Application WO-A-90 14604 discloses a proximity sensor comprising a sensing plate, a buffer plate positioned beneath the sensing plate and forming, together with the sensing plate, the electrodes of a capacitor, and a buffer ring located concentrically with the two plates. The sensing plate senses a change in ambient dielectric conditions, which may for example be due to the proximity of a hand or other object or to the presence of moisture in a wall or of a particular gas. The sensing plate is connected to an oscillator, such that any change in potential at the sensing plate due to changes in the ambient dielectric conditions causes a corresponding change in the frequency of the oscillator. Due to the location of the buffer plate and ring, the sensing plate is only sensitive to dielectric changes in a general direction in front of it, rather than to its side or behind it. One of the major shortcomings in combination with electronic sensors, switches, or transducers is not remedied by this conventional proximity sensor: An ESD (electro static discharge) transient appears when large static charges are induced on the outside of the housing of conventional electronic sensors for example by plastic granulates passing the head of the electronic sensor and / or rubbing the housing of the electronic sensor. With these large static charges discharging the capacitance sensing means, the resulting ESD transient often destroys the sensitive input of the unity gain buffer of the oscillator means.

British Patent Application GB-A-15 15 431 is directed to an electrical protection circuit precluding the build-up of high electrostatic potential differences in order to prevent electrical damage due to electrostatic discharges induced by the touch of a human being. Therefore, this British Patent Application discloses a high voltage protection circuit comprising a conductive touch plate adapted for physical contact with a human hand whereby said human hand may apply a potential to said plate, a first terminal for connection to a first potential, a second terminal for connection to a second potential, switch means having an input electrode, an output electrode, and a control electrode, said input electrode being connected to said second terminal, and said control electrode being connected to said touch plate, and a high voltage protection means connected between said touch plate and said first terminal, said protection means being conductive to electrostatic high voltage potentials and including a substrate supporting a printed circuit conductor having a gap in the conductor such that whenever the potential difference across the gap exceeds a predetermined magnitude a conductive path is established across the gap. Though this electrical high voltage circuit presents a means of protection against ESD transients, this kind of protection cannot be applied at all to conventional capacitive sensors because the capacitive changes to be measured by these capacitive sensors are very small, i. e. in the range below C ≈ 10⁻¹² Farad. Therefore, the implementation of such a principle, i. e. the application of a high voltage as described in this British Patent Application GB-A-15 15 431 and the resulting amount of charge would render any detection or measurement by the conventional capacitive sensor impossible. Furthermore, this conventional electrical protection circuit is not merely comparatively expensive, but also rather difficult to produce and operate because of its large number of components. Finally, it takes a lot of volume which is contradictory to the object of miniaturizing electrical or electronical devices a condition of which is providing small, even tiny electrical circuits to be implemented in those devices.

Since the electrostatic field spreads out in all directions from the capacitance sensing means of electronic sensors according to the prior art, the capacitance sensing means is sensitive to all directions.

In general, the exactness and reliability of electronic sensors according to the prior art have left much to be desired. That is the reason why the detection of a well-defined threshold distance has turned out to be nearly impossible. Therefore, the secure detection of an approaching object has been very difficult and extremely deficient.

In consideration of the problems described above, it is an object of the present invention to provide a capacitive sensor capable of detecting the frequency shift by an oscillator principle different from the prior art so as to guarantee a reliable detection of an approaching object. This object implies that the present invention provides a capacitive sensor capable of precisely and continuously reproducing the threshold condition for the detection. Another object of the present invention is to provide sensitivity of the capacitance sensing means just in the desired direction in order to avoid all capacitive changes due to electromagnetic interference as for instance electrostatic distortion. Finally, the present invention aims at preventing large static charges from discharging the capacitance sensing means in order not to destroy the sensitive input of the unity gain buffer of the oscillator means by the resulting ESD transient.

This object is achieved with a capacitive sensor of claim 1.

In an especially advantageous embodiment, the guard means is arranged as at least one line on at least one side and / or on the opposite side of the printed circuit board or in an inner layer of a multilayer printed circuit board.

The connection between the capacitance sensing means and the input of the unity gain buffer by a shielded cable is advantageously tightly connected to the guard means in order to guarantee a shielding of the sensitive parts of the device without a gap. This shielded cable is preferably attached to the central portion of the guard means.

Since the guard means preferably carries the same potential as the capacitance sensing means, the guard means does not have any capacitive influence on the capacitance sensing means. Generally, the guard means present an effective way of reducing the sensitivity of the capacitance sensing means with respect to the influence from electronics and molding material inside the capacitive sensor.

According to a particularly advantageous embodiment of the present invention, the protective means comprises a pair of diodes preferably directed in opposite ways. Since a common diode has a series capacitance of for instance about 5·10⁻¹² Farad, its capacitive load would be far too big to permit the detection of capacitive changes in the range below 10⁻¹² Farad. But with the potential on both sides of the diodes being the same, no potential is left across the protective means and, consequently, no current flows through the diodes under normal operation. In case, that an ESD transient is imposed on the capacitance sensing means, one of the diodes (depending on the polarity of the ESD transient) becomes conductive and leads the transient energy to the guard means. From the guard means, the transient energy is led to ground or to an additional terminal on a certain potential in any preferred way because capacitive load on the output of the unity gain buffer has no effect on the capacitance sensing means.

Under normal operating conditions, the guard means always carries the same potential as the capacitance sensing means. This means that under normal operating conditions none of the diodes will ever be conductive and therefore the equivalent circuit for them would be a very small, negligible leakage current. The capacitive influence of such protective means between the capacitance sensing means and the guard means is then cancelled out and no capacitive load is imposed on the capacitance sensing means. Thus, such protective means can be used as a protection against electromagnetic interference as for instance electrostatic distortion.

According to a further embodiment of the present invention, the input terminal of the unity gain buffer is of very low capacitance and of very high impedance. Since the capacitive changes to be measured by the capacitive sensor are very small, i. e. in the range below C ≈ 10⁻¹² Farad, just a few 10⁻¹² Farad in parallel with the capacitance sensing means would make the measurement impossible. In addition, the resistance R of the resistor has to be very big (in the range of up to R ≈ 10⁷ Ohm) so as to result in a time constant of τ = C·R ≈ 10⁻¹²·10⁷ sec = 10⁻⁵ sec or a frequency of fₒᵤₜ ≈ 1/τ ≈ 10⁵ Hertz of the oscillator means. With the period time Tₒᵤₜ = 1 / fₒᵤₜ of the oscillator means being about 10⁻⁵ sec and thus being relatively great compared with the duration time of an ESD transient (which is in the range of 10⁻⁹ sec), the disturbances of the output signal fₒᵤₜ caused by an ESD transient are extremely unlikely to produce detection errors.

In an advantageous embodiment of the present invention, the charging means are implemented by a trigger producing a high output signal V_{2,out} at its output terminal if the input signal V_{2,in} at its input terminal is below a certain lower threshold V_{low}. During this first half-period of the oscillation, current flows from the trigger output through the resistor and charges the capacitance sensing means. If the input signal V_{2,in} at the input terminal of the trigger is beyond a certain upper threshold Vᵤₚ the trigger produces a low output signal V_{2,out} at its output terminal resulting in a current flow from the capacitance sensing means via the resistor to the output of the trigger. Consequently, the voltage over the capacitance sensing means decreases during this second half-period of the oscillation. This cycle repeats itself at the above-mentioned frequency fₒᵤₜ ≈ 1/(C·R) .

Preferably, the charging means are implemented by an inverting Schmitt-trigger, or by an operational amplifier with appropriate external components, or by a block comprising discrete transistors.

In a particularly advantageous embodiment of the present invention, the capacitive sensor comprises frequency detection means for measuring the frequency variation of the signal fₒᵤₜ of the oscillator means. This frequency detection means preferably comprises a frequency divider (with a divisor n of e.g. 2¹⁰ = 1024), a reference oscillator, and a frequency comparator for comparing the divided frequency signal fₒᵤₜ/n of the oscillator means with the frequency signal f_{ref} of the reference oscillator. Since the reference oscillator can be trimmed, the provision of an ON / OFF output which is often used in capacitive proximity switches and which is dependent on a certain externally adjustable threshold point is possible. Needless to say, that dividing the frequency fₒᵤₜ by n has a desirable integrating effect, i. e. small erroneous variations of the period time Tₒᵤₜ = 1 / fₒᵤₜ due to an ESD transient are levelled out.

Alternatively, the frequency detection means can also comprise a rectifier, a low-pass filter, a local oscillator, and a modulator for mixing the frequency signal fₒᵤₜ of the oscillator means with the frequency signal f_{loc} of the local oscillator which is for example tuned to zero-beat frequency. By mixing fₒᵤₜ and f_{loc}, a characteristic beat frequency f_{beat} is produced. The subsequent low-pass filter cuts off high frequencies beyond a certain threshold and lets pass through only the characteristic beat frequency f_{beat} as it is desired.

The present invention will be described in more detail below with reference to the exemplary embodiments which are schematically illustrated in the following drawings, in which:
Fig. 1 is a view of a circuit diagram showing an example of a capacitive sensor in accordance with the invention;
Fig. 2 is a magnified view in transversal section of the capacitance sensing means and of the guard means of a capacitive sensor according to the invention;
Fig. 3 is another magnified view in transversal section of the capacitance sensing means and of the guard means of a capacitive sensor according to the invention;
Fig. 4 is a view in transversal section of a printed circuit board of a capacitive sensor according to the invention;
Fig. 5 is a top view of the printed circuit board shown in Fig. 4;
Fig. 6 is another view in transversal section of a printed circuit board of a capacitive sensor according to the invention;
Fig. 7 is a schematic view of an embodiment of the frequency detection means;
Fig. 8 is a schematic view of another embodiment of the frequency detection means;
Fig. 9 is a circuit diagram of the charging means, here realized as an inverting Schmitt-trigger;
Fig. 10 is a diagram of the voltage curve of the inverting Schmitt-trigger shown in Fig. 9;
Fig. 11 is a diagram of the transfer characteristic of the inverting Schmitt-trigger shown in Fig. 9.

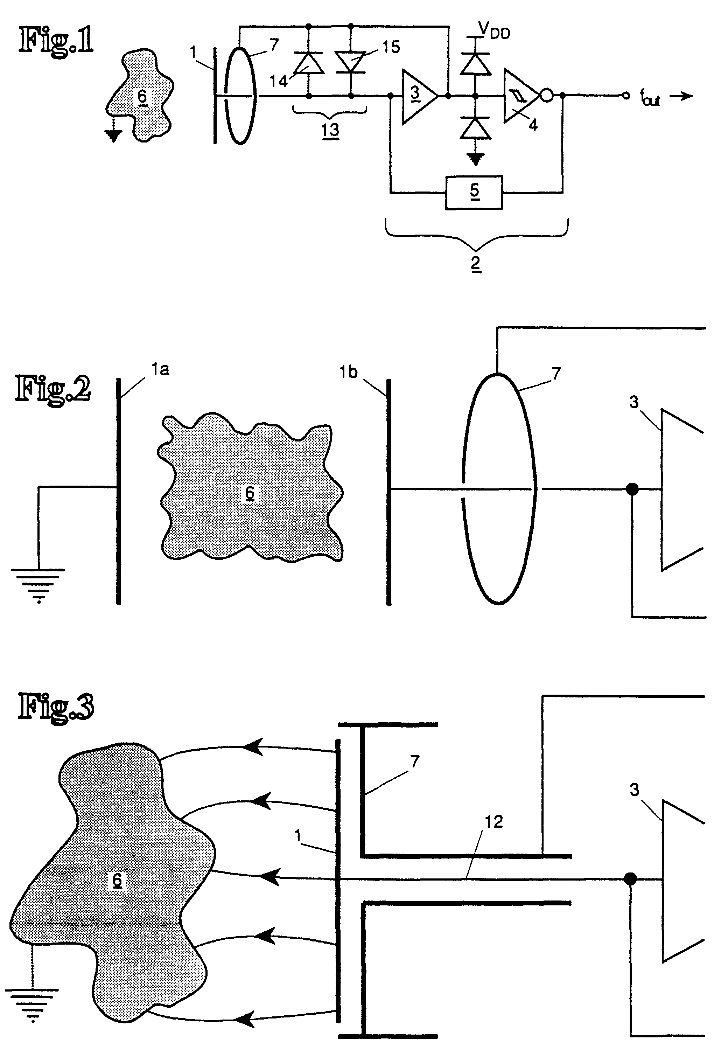

An example of realizing the capacitive sensor in accordance with the invention is illustrated in figure 1. This capacitive sensor can for example be implemented in an electric control circuit or in an electric regulator circuit in order to detect how close an object 6 has approached the capacitive sensor. This capacitive sensor can also be used to detect whether a physical quantity of a medium the capacitive sensor is sensitive for has reached a corresponding predetermined value. Needless to say, that the capacitive sensor can also be used to sense capacitive changes in many other applications as for example capacitive relative humidity sensors or capacitive membrane cells for pressure measurements. The basic principle of this capacitive sensor which will be explained in more detail below is as follows: as the capacity of the capacitance sensing means 1 changes with the approaching object 6 or the quantity to be measured, the frequency fₒᵤₜ of the output of this capacitive sensor changes with it.

The embodiment of a capacitive sensor according to the invention shown in figure 1 comprises the capacitance sensing means 1 and oscillator means 2 for detecting the presence of the object 6 placed at a variable distance in front of the capacitance sensing means 1. The oscillator means 2 is provided with a unity gain buffer 3 (where "unity" stands for an amplification factor of 1 of the gain buffer 3) for buffering the voltage over the capacitance sensing means 1 without imposing any load on the capacitance sensing means which consists in figure 1 of a conductive sensing plate 1 connected to the input terminal of the unity gain buffer 3. The output terminal of the unity gain buffer 3 is connected to the input terminal of charging means 4 for charging and discharging the capacitance sensing means 1 between some voltage levels (depending on the voltage applied to the input terminal of the charging means 4) via a resistor 5 which is connected to the capacitance sensing means 1 and to the output of the charging means 4 and which is very big (in the range of up to R ≈ 10⁷ Ohm). Frequency detection means not illustrated in figure 1 is connected in series to the oscillator means 2. Furthermore, it is not shown that positive supply is applied to the unity gain buffer 3 and/or the charging means 4.

Guard means 7 connected to the output of the unity gain buffer 3 and provided close to the capacitance sensing means 1 is symbolically shown in figure 1. Furthermore, a protective means 13 is placed between the capacitance sensing means 1 and the guard means 7 in order to avoid the negative effects of an ESD (electro static discharge) transient which appears when large static charges are induced on the outside of the housing of the capacitive sensor for example by plastic granulates passing the head of the capacitive sensor and / or rubbing the housing of the capacitive sensor. With these large static charges discharging to the capacitance sensing means 1, the resulting ESD transient would destroy the sensitive input of the unity gain buffer 3 of the oscillator means 2.

In figure 1, the protective means 13 comprises a pair of diodes 14, 15 directed in opposite ways. With the potential on both sides of these diodes 14, 15 being always the same, no potential is left across the protective means 13 and, consequently, no current flows through the diodes 14, 15 under normal operation. In case, that an ESD transient is imposed on the capacitance sensing means 1, one of the diodes 14, 15 (depending on the polarity of the ESD transient) becomes conductive and leads the transient energy to the guard means 7. From the guard means 7, the transient energy is led to ground or to an additional terminal V_{DD} on a certain potential because capacitive load on the output of the unity gain buffer 3 has no effect on the capacitance sensing means 1.

Under normal operating conditions, the guard means 7 carries the same potential as the capacitance sensing means 1. This means that under normal operating conditions none of the diodes 14, 15 will ever be conductive and therefore the equivalent circuit for them would be a very small, negligible leakage current. The capacitive influence of such protective means 13 between the capacitance sensing means 1 and the guard means 7 is then cancelled out and no capacitive load is imposed on the capacitance sensing means 1. Thus, such protective means 13 can be used as a protection against electromagnetic interference as for instance electrostatic distortion.

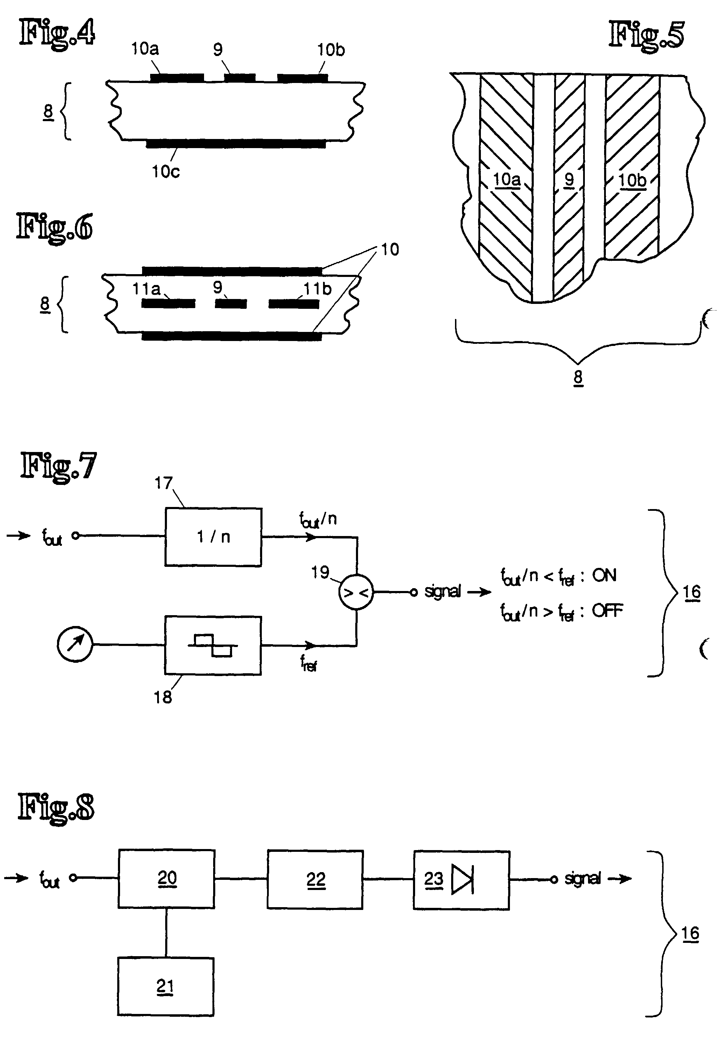

Figure 2 shows a magnified view in transversal section of the guard means 7 as well as of the capacitance sensing means 1 of a capacitive sensor in accordance with the invention. An object 6, for example a solid or a liquid of any shape and volume, is placed between the capacitance sensing means which comprises two conductive sensing plates 1a, 1b in the embodiment illustrated in figure 2. The first conductive plate 1a is connected to ground and therefore carries vanishing potential, the other conductive plate 1b is connected with the input terminal of the unity gain buffer 3 (which is of very low capacitance and of very high impedance).

Figure 3 shows a magnified view in transversal section of the guard means 7 as well as of the capacitance sensing means 1 of another capacitive sensor in accordance with the invention. Like in figure 1, the capacitance sensing means is realized as a conductive sensing plate 1. Since the guard means 7 carries the same potential as the conductive sensing plate 1, the guard means 7 does not have any capacitive influence on the conductive sensing plate 1.

As it can be seen from figure 3, the guard means 7 is arranged laterally to and close behind the conductive sensing plate 1 to shield capacitive changes at the side or at the rear of the conductive sensing plate 1. Consequently, sensitivity just in front of the conductive sensing plate 1 is warranted, and all capacitive changes in the direction of the sides and / or of the rear of the conductive sensing plate 1 affect only this guard means 7. Thus, the electrostatic field which is exemplarily illustrated by five lines of electric flux spreading out from the conductive sensing plate 1 to the object 6 to be detected is confined to the region in front of the conductive sensing plate 1. All in all, the guard means 7 present an effective way of reducing the lateral and rear sensitivity of the conductive sensing plate 1 with respect to the influence from electronics and molding material inside the capacitive sensor.

The connection between the conductive sensing plate 1 and the input terminal of the unity gain buffer 3 (which is of very low capacitance and of very high impedance) is provided by a shielded cable 12 which is tightly connected to the guard means 7 in order to guarantee a shielding of the sensitive parts of the device without a gap. According to the embodiment shown in figure 3, the shielded cable 12 is attached to the central portion of the guard means 7.

Figures 4, 5 and figure 6 show two different embodiments of the printed circuit board 8 of the capacitive sensor according to the invention. With the capacitance sensing means 1 being preferably connected to the input of the unity gain buffer 3, this connection between the capacitance sensing means 1 and the input of the unity gain buffer 3 is provided by a line 9 on the printed circuit board 8. In figure 4, which shows a transversal section, as well as in figure 5, which is a top view, the guard means 7 is arranged as two lines 10a, 10b on the one side of the printed circuit board 8 and as one line 10c on the opposite side of the printed circuit board 8. In figure 6, which is a view also in transversal section of another printed circuit board 8 of a capacitive sensor according to the invention, the guard means 7 is arranged as two lines 10 on both sides of a multilayer printed circuit board 8 and as two lines 11a, 11b in an inner layer of the multilayer printed circuit board 8. Furthermore, the line 9 connecting the capacitance sensing means 1 and the input of the unity gain buffer 3 is embedded between the two lines 11a, 11b of the guard means 7 within the multilayer printed circuit board 8.

Figures 7 and 8 show two schematic views of the frequency detection means 16 arranged in series to the capacitance sensing means 1 and to the oscillator means 2. Generally, measuring the frequency of an alternating voltage is realized by comparing it with an exactly defined and calculable mechanical or electric resonance phenomenon. The most exact results for such frequency measurements can be obtained by beat-frequency meters which compare the frequency to be measured with a frequency standard. The latter can be defined by an atomic reference oscillator, by a quartz, crystal or piezoelectric reference oscillator, or by a synthesizer. At the best, this frequency standard is chosen in such way that the resulting difference frequency or beat frequency vanishes which can be indicated by a headset or by an instrument.

The frequency detection means 16 shown in figure 7 and designated for measuring the frequency variation of a signal fₒᵤₜ of the oscillator means 2 comprises a frequency divider 17, a reference oscillator 18, and a frequency comparator 19 for comparing the divided frequency signal fₒᵤₜ/n of the oscillator means 2 with the frequency signal f_{ref} of the reference oscillator 18. Since the reference oscillator 18 can be trimmed, the provision of an ON / OFF output which is often used in capacitive proximity switches and which is dependent on a certain externally adjustable threshold point is possible. In the example of figure 7, the output is ON in the case that the divided frequency signal fₒᵤₜ/n of the oscillator means 2 is smaller than the frequency signal f_{ref} of the reference oscillator 18. For the divided frequency signal fₒᵤₜ/n of the oscillator means 2 being greater than the frequency signal f_{ref} of the reference oscillator 18, the output is OFF. Needless to say, that the frequency division of fₒᵤₜ by n has a desirable integrating effect, i. e. small erroneous variations of the single period time Tₒᵤₜ = 1 / fₒᵤₜ due to an ESD transient are levelled out.

The frequency detection means 16 shown in figure 8 and also designated for measuring the frequency variation of a signal fₒᵤₜ of the oscillator means 2 comprises a rectifier 23, a low-pass filter 22, a local oscillator 21, and a modulator 20. In the modulator 20, the frequency signal fₒᵤₜ is mixed and thus compared with the frequency standard f_{loc} produced by the local oscillator 21. The subsequent low-pass filter 22 cuts off the high frequencies beyond a certain threshold and lets pass through only the difference frequency f_{diff} or the beat frequency f_{beat}. After having passed the rectifier 23 the resulting signal is sent to a display instrument not shown in figure 8.

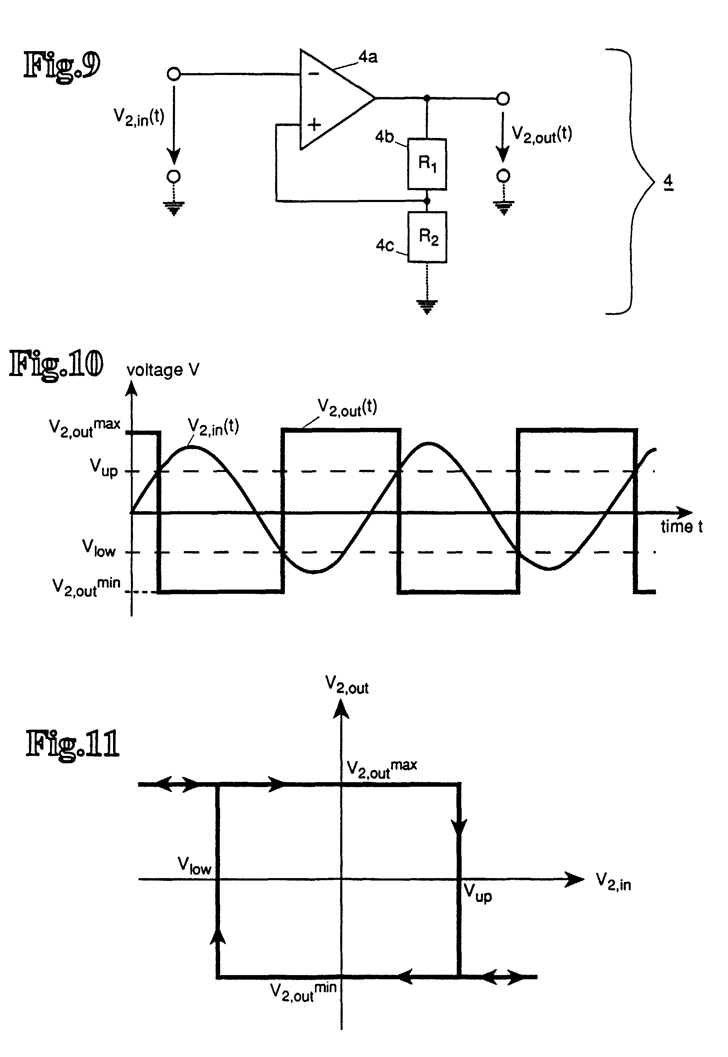

Figure 9 is a circuit diagram of the charging means, here realized as an inverting Schmitt-trigger 4. As it is illustrated by the diagram of its voltage curve in figure 10, this inverting Schmitt-trigger 4 produces a high output signal V_{2,out} at its output terminal if the input signal V_{2,in} at its input terminal is below a certain lower threshold V_{low}. During this first half-period of an oscillation, current flows from the output of the inverting Schmitt-trigger 4 through the resistor 5 and charges the capacitance sensing means 1. If the input signal V_{2,in} at the input terminal of the inverting Schmitt-trigger 4 is beyond a certain upper threshold Vᵤₚ the inverting Schmitt-trigger 4 produces a low output signal V_{2,out} at its output terminal resulting in a current flow from the capacitance sensing means 1 via the resistor 5 to the output of the inverting Schmitt-trigger 4. Consequently, the voltage over the capacitance sensing means 1 decreases during this second half-period of the oscillation. This cycle repeats itself at the frequency fₒᵤₜ ≈ 1/(C·R) where C is the capacity of the capacitance sensing means 1 and R is the resistance of the resistor 5.

The inverting Schmitt-trigger 4 of figure 9 comprises a comparator 4a as well as a voltage divider 4b, 4c consisting of a first resistor (resistance R₁) and of a second resistor (resistance R₂). Such a Schmitt-trigger 4 offers as a special feature that its turn-on-level V_{low} = V_{2,out} ^{min} · R₂ / (R₁ + R₂) does not coincide with its turn-off-level Vᵤₚ = V_{2,out} ^{max} · R₂ / (R₁ + R₂) but the two differ by a switching backlash ΔV_{sb} = (V_{2,out} ^{max} - V_{2,out} ^{min}) · R₂ / (R₁ + R₂) (for an illustration of V_{low} and Vᵤₚ as well as of V_{2,out}^{min} and V_{2,out}^{max} confer to the diagram of the voltage curve of the inverting Schmitt-trigger 4 in figure 10 as well as to the transfer characteristic of the inverting Schmitt-trigger 4 in figure 11). In the inverting Schmitt-trigger 4 such as shown in figure 9, this switching backlash ΔV_{sb} is produced by a so-called regenerative feedback of the comparator 4a via the voltage divider 4b, 4c. For a great negative voltage V_{2,in} at the input terminal of the inverting Schmitt-trigger 4, V_{2,out} at its output terminal reaches the maximum value V_{2,out}^{max}. In this case, the maximum potential Vᵤₚ at the P-input terminal of the comparator 4a of the inverting Schmitt-trigger 4 is therefore given by Vᵤₚ = V_{2,out} ^{max} · R₂ / (R₁ + R₂) . With increasing voltage V_{2,in}(t) at the input terminal of the inverting Schmitt-trigger 4, the voltage V_{2,out}(t) at its output terminal is not changed during the first half-period of the oscillation. But with the voltage V_{2,in}(t) at the input terminal of the inverting Schmitt-trigger 4 reaching the value Vᵤₚ, the voltage V_{2,out}(t) at its output terminal abruptly and rapidly decreases to the value V_{2,out}^{min} because of regenerative feedback: the decrease of the voltage V_{2,out}(t) at the output terminal of the inverting Schmitt-trigger 4 implies the decrease of the voltage at the P-input terminal of the comparator 4a of the inverting Schmitt-trigger 4, i. e. the difference value of the voltage at the P-input terminal minus the voltage at the N-input terminal becomes negative which forms a regenerative feedback. As a result, the potential at the P-input terminal of the comparator 4a of the inverting Schmitt-trigger 4 reaches its minimum value V_{low} = V_{2,out} ^{min} · R₂ / (R₁ + R₂) . Now, the difference value of the voltage at the P-input terminal minus the voltage at the N-input terminal becomes very negative, and the state of the inverting Schmitt-trigger 4 is stable during this second half-period of the oscillation as long as the voltage V_{2,in}(t) at the input terminal of the inverting Schmitt-trigger 4 has not yet reached the value V_{low}. If the latter is the case, the voltage V_{2,out}(t) at the output terminal of the inverting Schmitt-trigger 4 abruptly and rapidly increases to the value V_{2,out}^{max} which forms the end of the second half-period of the oscillation.

The mode of operation of the inverting Schmitt-trigger 4 which has been explained above is additionally illustrated by the diagram of its voltage curve in figure 10 as well as by its transfer characteristic in figure 11.

## Claims

1. A capacitive sensor comprising capacitance sensing means (1) in the form of at least one conductive sensing plate arranged to detect the presence of an object (6) placed at a variable distance and oscillator means (2), for measuring capacitive changes, the oscillator means (2) comprising a unity gain buffer (3), the input terminal of which being connected to the capacitance sensing means (1) by a line (9) on a printed circuit board (8) or by a shielded cable (12), for buffering the voltage over the capacitance sensing means (1) without imposing any load on the latter, the output terminal of the unity gain buffer (3) being connected to the input terminal of charging means (4) for charging and discharging the capacitance sensing means (1) via a resistor (5) which is connected to the capacitance sensing means (1) and to the output terminal of the charging means (4), the capacitive sensor further comprising guard means (7) connected to the output terminal of the unity gain buffer (3) and arranged as at least one line (10) on at least one side and / or on the opposite side of a printed circuit board (8) to at least partially surround the capacitance sensing means (1) to shield the capacitance sensing means (1) from capacitive changes caused by interferential action, wherein a protective means (13) is connected between the capacitance sensing means (1) and the guard means (7).

2. A capacitive sensor according to claim 1, characterized in that the guard means (7) is arranged as at least one line (11) in an inner layer of a multilayer printed circuit board (8).

3. A capacitive sensor according to claim 1 or 2, characterized in that the shielded cable (12) is tightly connected to the guard means (7).

4. A capacitive sensor according to claim 3, characterized in that the shielded cable (12) is attached to the central portion of the guard means (7).

5. A capacitive sensor according to any of the claims 1 to 4, characterized in that the guard means (7) carries the same potential as the capacitance sensing means (1).

6. A capacitive sensor according to any of the claims 1 to 5, characterized in that the protective means (13) comprises a pair of diodes (14, 15) directed in opposite ways.

7. A capacitive sensor according to any of the claims 1 to 6, characterized in that the input terminal of the unity gain buffer (3) is of very low capacitance and of very high impedance.

8. A capacitive sensor according to any of the claims 1 to 7, characterized in that the charging means are implemented by a trigger (4) producing a high output signal V_{2,out} at its output terminal if the input signal V_{2,in} at its input terminal is below a certain lower threshold V_{low}, and producing a low output signal V_{2,out} at its output terminal if the input signal V_{2,in} at its input terminal is beyond a certain upper threshold Vᵤₚ.

9. A capacitive sensor according to claim 8, characterized in that the charging means (4) are implemented by an inverting Schmitt-trigger, or by an operational amplifier with appropriate external components, or by a block comprising discrete transistors.

10. A capacitive sensor according to any of the claims 1 to 9, characterized in that the capacitive sensor comprises frequency detection means (16) for measuring the frequency variation of a signal fout of the oscillator means (2).

11. A capacitive sensor according to claim 10, characterized in that the frequency detection means (16) comprises a frequency divider (17), a reference oscillator (18), and a frequency comparator (19) for comparing the divided frequency signal fₒᵤₜ/n of the oscillator means (2) with the frequency signal f_{ref} of the reference oscillator (18).

12. A capacitive sensor according to claim 10, characterized in that the frequency detection means (16) comprises a rectifier (23), a low-pass filter (22), a local oscillator (21), and a modulator (20) for mixing the frequency signal fₒᵤₜ of the oscillator means (2) with the frequency signal floc of the local oscillator (21).

## Patentansprüche

1. Kapazitiver Sensor, der Kapazitätssensormittel (1) in der Form von wenigstens einer leitenden Sensorplatte aufweist, die so angeordnet ist, dass das Vorhandensein eines Objektes (6), das in einem variablen Abstand plaziert ist, festgestellt wird, und Oszillatormittel (2) zur Messung der kapazitiven Änderungen aufweist, wobei die Oszillatormittel (2) einen Einheitsverstärkungspuffer (3) aufweisen, dessen Eingangsanschluß mit den Kapazitätssensormitteln (1) über eine Leitung (9) auf einer gedruckten Leiterplatte (8) oder durch ein Abschirmkabel (12) verbunden ist, zur Pufferung der Spannung über die Kapazitätssensormittel (1) ohne irgendeine Last auf die Letzteren zu legen, wobei der Ausgangsanschluß des Einheitsverstärkungspuffers (3) mit dem Eingangsanschluß der Lademittel (4) verbunden ist, um die Kapazitätssensormittel (1) über einen Widerstand (5) zu laden und zu entladen, welcher Widerstand mit den Kapazitätssensormitteln (1) und dem Ausgangsanschluß der Lademittel (4) verbunden ist, der kapazitive Sensor außerdem Schirmmittel (7) aufweist, die mit dem Ausgangsanschluß des Einheitsverstärkerungspuffers (3) verbunden und so angeordnet sind, dass sie bei wenigstens einer Leitung (10) an wenigstens einer Seite und/oder an der entgegengesetzten Seite einer gedruckten Leiterplatte (8) mindestens die Kapazitätssensormittel (1) teilweise umgeben, um die Kapazitätssensormittel (1) vor kapazitiven Änderungen zu schützen, die durch Interferenzprozesse verursacht werden, wobei Schutzmittel (13) zwischen die Kapazitätssensormittel (1) und die Schirmmittel (7) geschaltet sind.

2. Kapazitiver Sensor nach Anspruch 1, dadurch gekennzeichnet, dass die Schirmmittel (7) als mindestens eine Leitung (11) in einer Innenschicht einer mehrschichtigen gedruckten Leiterplatte (8) angeordnet sind.

3. Kapazitiver Sensor nach Anspruch 1 oder 2, dadurch gekennzeichnet, dass das Abschirmkabel (12) fest mit den Schirmmitteln (7) verbunden ist.

4. Kapazitiver Sensor nach Anspruch 3, dadurch gekennzeichnet, dass das Abschirmkabel (12) an dem zentralen Abschnitt der Schirmmittel (7) befestigt ist.

5. Kapazitiver Sensor nach irgendeinem der Ansprüche 1 bis 4, dadurch gekennzeichnet, dass die Schirmmittel (7) das gleiche Potential wie die Kapazitätssensormittel (1) tragen.

6. Kapazitiver Sensor nach irgendeinem der Ansprüche 1 bis 5, dadurch gekennzeichnet, dass die Schutzmittel (13) ein Paar von Dioden (14, 15) aufweisen, die entgegengesetzt gerichtet sind.

7. Kapazitiver Sensor nach irgendeinem der Ansprüche 1 bis 6, dadurch gekennzeichnet, dass der Eingangsanschluß des Einheitsverstärkungspuffers (3) eine sehr niedrige Kapazität und eine sehr hohe Impedanz hat.

8. Kapazitiver Sensor nach irgendeinem der Ansprüche 1 bis 7, dadurch gekennzeichnet, dass die Lademittel durch einen Trigger (4) implementiert sind, der ein hohes Ausgangssignal V_{2,out} an seinem Ausgangsanschluß erzeugt, wenn das Eingangssignal V_{2,in} an seinem Eingangsanschluß unter einem bestimmten niedrigeren Schwellenwert V_{low} liegt, und der ein niedriges Ausgangssignal V_{2,out} an seinem Ausgangsanschluß erzeugt, wenn das Eingangssignal V_{2,in} an seinem Eingangsanschluß über einem bestimmten oberen Schwellenwert Vᵤₚ liegt.

9. Kapazitiver Sensor nach Anspruch 8, dadurch gekennzeichnet, dass die Ladungsmittel (4) durch einen invertierenden Schmitt-Trigger oder durch einen Operationsverstärker mit geeigneten externen Komponenten oder durch einen Block mit diskreten Transistoren implementiert sind.

10. Kapazitiver Sensor nach irgendeinem der Ansprüche 1 bis 9, dadurch gekennzeichnet, dass der kapazitive Sensor Frequenznachweismittel (16) zur Messung der Frequenzänderung eines Signals fₒᵤₜ der Oszillatormittel (2) aufweist.

11. Kapazitiver Sensor nach Anspruch 10, dadurch gekennzeichnet, dass die Frequenznachweismittel (16) einen Frequenzteiler (17), einen Referenzoszillator (18) und einen Frequenzvergleicher (19) zum Vergleich des geteilten Frequenzsignals fₒᵤₜ/n der Oszillatormittel (2) mit dem Frequenzsignal f_{ref} des Referenzoszillators (18) aufweisen.

12. Kapazitiver Sensor nach Anspruch 10, dadurch gekennzeichnet, dass die Frequenznachweismittel (16) einen Gleichrichter (23), ein Tiefpaßfilter (22), einen Mischoszillator (21) und einen Modulator (20) zur Mischung des Frequenzsignals fₒᵤₜ der Oszillatormittel (2) mit dem Frequenzsignal f_{loc} des Mischoszillators (21) aufweisen.

## Revendications

1. Capteur capacitif comprenant des moyens de détection de capacité (1) sous la forme d'au moins une plaque de détection conductrice conçue pour détecter la présence d'un objet (6) placé à une distance variable, et des moyens oscillateurs (2), pour mesurer des changements capacitifs, les moyens oscillateurs (2) comprenant un amplificateur-séparateur à gain unité (3), dont la borne d'entrée est connectée aux moyens de détection de capacité (1) par une piste (9) sur une carte de circuit imprimé (8) ou par un câble blindé (12), pour effectuer une amplification-séparation de la tension sur les moyens de détection de capacité (1) en n'imposant aucune charge à ces derniers, la borne de sortie de l'amplificateur-séparateur à gain unité (3) étant connectée à la borne d'entrée de moyens de charge (4) pour charger et décharger les moyens de détection de capacité (1) par l'intermédiaire d'une résistance (5) qui est connectée aux moyens de détection de capacité (1) et à la borne de sortie des moyens de charge (4), le capteur capacitif comprenant en outre des moyens de garde (7) connectés à la borne de sortie de l'amplificateur-séparateur à gain unité (3) et réalisés sous la forme d'au moins une piste (10) sur au moins une face et/ou sur la face opposée d'une carte de circuit imprimée (8) pour entourer au moins partiellement les moyens de détection de capacité (1), de façon à blinder les moyens de détection de capacité (1) vis-à-vis de changements capacitifs occasionnés par une action parasite, dans lequel des moyens de protection (13) sont connectés entre les moyens de détection de capacité (1) et les moyens de garde (7).

2. Capteur capacitif selon la revendication 1, caractérisé en ce que les moyens de garde (7) sont réalisés sous la forme d'au moins une piste (11) dans une couche intérieure d'une carte de circuit imprimé multicouche (8).

3. Capteur capacitif selon la revendication 1 ou 2, caractérisé en ce que le câble blindé (12) est fermement connecté aux moyens de garde (7).

4. Capteur capacitif selon la revendication 3, caractérisé en ce que le câble blindé (12) est fixé à la partie centrale des moyens de garde (7).

5. Capteur capacitif selon l'une quelconque des revendications 1 à 4, caractérisé en ce que les moyens de garde (7) portent le même potentiel que les moyens de détection de capacité (1).

6. Capteur capacitif selon l'une quelconque des revendications 1 à 5, caractérisé en ce que les moyens de protection (13) comprennent une paire de diodes (14, 15) orientées dans des directions opposées.

7. Capteur capacitif selon l'une quelconque des revendications 1 à 6, caractérisé en ce que la borne d'entrée de l'amplificateur-séparateur à gain unité (3) a une très faible capacité et une très haute impédance.

8. Capteur capacitif selon l'une quelconque des revendications 1 à 7, caractérisé en ce que les moyens de charge sont réalisés par une bascule (4) produisant un signal de sortie V_{2,out} de niveau haut sur sa borne de sortie si le signal d'entrée V_{2,in} sur sa borne d'entrée est inférieur à un certain seuil inférieur V_{low}, et produisant un signal de sortie V_{2,out} de niveau bas sur sa borne de sortie si le signal d'entrée V_{2,in} sur sa borne d'entrée est supérieur à un certain seuil supérieur Vᵤₚ.

9. Capteur capacitif selon la revendication 8, caractérisé en ce que les moyens de charge (4) sont réalisés par une bascule de Schmitt inverseuse, ou par un amplificateur opérationnel avec des composants externes appropriés, ou par un sous-ensemble comprenant des transistors discrets.

10. Capteur capacitif selon l'une quelconque des revendications 1 à 9, caractérisé en ce que le capteur capacitif comprend des moyens de détection de fréquence (16) pour mesurer la variation de fréquence d'un signal fout des moyens oscillateurs (2).

11. Capteur capacitif selon la revendication 10, caractérisé en ce que les moyens de détection de fréquence (16) comprennent un diviseur de fréquence (17), un oscillateur de référence (18) et un comparateur de fréquence (19) pour comparer le signal de fréquence divisé fₒᵤₜ/n des moyens oscillateurs (2) avec le signal de fréquence f_{ref} de l'oscillateur de référence (18).

12. Capteur capacitif selon la revendication 10, caractérisé en ce que les moyens de détection de fréquence (16) comprennent un redresseur (23), un filtre passe-bas (22), un oscillateur local (21) et un modulateur (20) pour mélanger le signal de fréquence fout des moyens oscillateurs (2) avec le signal de fréquence f_{loc} de l'oscillateur local (21).
